# EUROPÄISCHE PATENTSCHRIFT

(11) **EP 2 076 575 B1**
(45) Veröffentlichungstag und Bekanntmachung des Hinweises auf die Patenterteilung: **11.05.2011**
(21) Anmeldenummer: 07820527.5
(22) Anmeldetag: 24.09.2007
(51) Int. Cl.: C09J 7/00

(54) **HITZEAKTIVIERBARES KLEBEBAND INSBESONDERE FÜR DIE VERKLEBUNG VON ELEKTRONISCHEN BAUTEILEN UND LEITERBAHNEN**
HEAT-ACTIVABLE ADHESIVE TAPE PARTICULARLY FOR BONDING ELECTRONIC COMPONENTS AND CONDUCTOR TRACKS
RUBAN ADHESIF ACTIVABLE THERMIQUEMENT, EN PARTICULIER POUR LE COLLAGE DE COMPOSANTS ELECTRONIQUES ET DE PISTES CONDUCTRICES.

(30) Priorität: 06.10.2006 DE 102006047739
(43) Veröffentlichungstag der Anmeldung: 08.07.2009
(73) Patentinhaber: TESA SE, 20253 Hamburg (DE)
(72) Erfinder: KRAWINKEL, Thorsten, 22457 Hamburg (DE); RING, Christian, 21435 Stelle (DE); ECE, Sevil, 22763 Hamburg (DE)
(86) Internationale Anmeldenummer: PCT/EP2007/060121
(87) Internationale Veröffentlichungsnummer: WO 2008/043662

(56) Entgegenhaltungen:
- EP-A- 0 087 075
- DE-A1- 4 224 567
- US-A- 5 605 944
- US-A1- 2003 062 630

## Beschreibung

Die Erfindung betrifft eine hitzeaktivierbare Klebmasse mit geringem Fließvermögen bei hohen Temperaturen insbesondere zur Verklebung von flexiblen gedruckten Leiterbahnen (Flexible Printed Circuit Boards, FPCBs).

Flexible Printed Circuit Boards werden heutzutage in einer Vielzahl von elektronischen Geräten wie Handys, Radios, Computern, Druckern und vielen anderen eingesetzt. Sie sind aufgebaut aus Schichten von Kupfer und einem hochschmelzenden widerstandsfähigen Thermoplasten, meistens Polyimid, seltener Polyester. Für die Herstellung dieser FPCBs werden häufig Klebebänder mit besonders hohen Ansprüchen eingesetzt. Zum einen werden zur Herstellung der FPCBs die Kupferfolien mit den Polyimidfolien verklebt, zum anderen werden auch einzelne FPCBs miteinander verklebt, in diesem Fall findet eine Verklebung von Polyimid auf Polyimid statt. Daneben werden die FPCBs auch auf andere Substrate geklebt.

An die Klebebänder, die für diese Verklebungen eingesetzt werden, werden sehr hohe Ansprüche gestellt. Da sehr hohe Verklebungsleistungen erreicht werden müssen, werden im Allgemeinen hitzeaktivierbare Klebebänder eingesetzt, die bei hohen Temperaturen verarbeitet werden. Diese Klebebänder dürfen während dieser hohen Temperaturbelastung bei der Verklebung der FPCBs, die häufig bei Temperaturen um 200 °C stattfindet, keine flüchtigen Bestandteile abgeben. Um eine hohe Kohäsion zu erreichen, sollten die Klebebänder während dieser Temperaturbelastung vernetzen. Hohe Drücke während des Verklebungsprozesses machen es nötig, dass die Klebebänder bei hohen Temperaturen nur eine geringe Fließfähigkeit besitzen. Dieses wird durch hohe Viskosität des unvernetzten Klebebandes oder durch eine sehr schnelle Vernetzung erreicht. Zudem müssen die Klebebänder noch lötbadbeständig sein, das heißt, für eine kurze Zeit eine Temperaturbelastung von 288 °C überstehen.

Aus diesem Grund ist der Einsatz von reinen Thermoplasten nicht sinnvoll, obwohl diese sehr leicht aufschmelzen, für eine gute Benetzung der zu verklebenden Substrate sorgen und zu einer sehr schnellen Verklebung innerhalb von wenigen Sekunden führen. Andererseits sind diese bei hohen Temperaturen so weich, dass sie bei Verklebung unter Druck zum Herausquellen aus der Klebfuge neigen. Damit ist auch keine Lötbadbeständigkeit gegeben.

Üblicherweise werden für vernetzbare Klebebänder Epoxidharze oder Phenolharze eingesetzt, die mit bestimmten Härtern zu polymeren Netzwerken reagieren. In diesem speziellen Fall sind die Phenolharze nicht einsetzbar, da sie bei der Vernetzung Abspaltprodukte erzeugen, die freigesetzt werden und während der Aushärtung oder spätestens im Lötbad zu einer Blasenbildung führen.

Epoxidharze werden hauptsächlich in der Konstruktionsverklebung eingesetzt und ergeben nach der Aushärtung mit entsprechenden Vernetzern sehr spröde Klebmassen, die zwar hohe Klebfestigkeiten erreichen, aber kaum flexibel sind.

Eine Steigerung der Flexibilität ist für den Einsatz in FPCBs unumgänglich. Zum einen soll die Verklebung mit Hilfe eines Klebebandes geschehen, das idealerweise auf eine Rolle gewickelt ist, zum anderen handelt es sich um flexible Leiterbahnen, die auch gebogen werden müssen, gut zu erkennen am Beispiel der Leiterbahnen in einem Laptop, bei dem der aufklappbare Bildschirm über FPCBs mit den weiteren Schaltungen verbunden ist.

Eine Flexibilisierung dieser Epoxidharzkleber ist auf zwei Arten möglich. Zum einen existieren mit Elastomerketten flexibilisierte Epoxidharze, die aber durch die sehr kurzen Elastomerketten nur eine begrenzte Flexibilisierung erfahren. Die andere Möglichkeit ist, die Flexibilisierung durch die Zugabe von Elastomeren zu erreichen, die der Klebmasse zugegeben werden. Diese Variante hat den Nachteil, dass die Elastomere chemisch nicht vernetzt werden, wodurch nur solche Elastomere zum Einsatz kommen können, die bei hohen Temperaturen immer noch eine hohe Viskosität aufweisen.

Da die Klebebänder meistens aus Lösung hergestellt werden, ist es häufig schwierig, Elastomere zu finden, die langkettig genug sind, um bei hohen Temperaturen nicht zu fließen, andererseits aber noch so kurzkettig sind, dass sie in Lösung gebracht werden können.

Eine Herstellung über einen Hotmelt-Prozess ist bei vernetzenden Systemen nur sehr schwierig möglich, da eine frühzeitige Vernetzung während des Herstellprozesses vermieden werden muss.

Besonders kohäsive und hochklebfeste Massen können durch den Einsatz eines löslichen Polyamids, das mit Epoxidharzen vernetzt wird, erzielt werden. Nachteilig ist, dass diese Klebmassen einen sehr hohen Erweichungspunkt haben.

Durch den hohen Erweichungspunkt der Polyamide ist eine Verarbeitung erst bei hohen Temperaturen möglich. Zudem besitzen Klebmassen aus Polyamid, Epoxidharz und Härtern nur begrenzte Lagerstabilität.

Vernetzbare Klebmassen auf der Basis von Polyamid oder deren Derivaten sind beschrieben.

Dabei handelt es sich wie in US 5,885,723 A oder JP 10 183 074 A beziehungsweise JP 10 183 073 A um modifizierte Polyamide, die bevorzugt Polycarbonat- oder Polyalkylenglycolgruppen enthalten. Die Polyamide werden dabei so umgesetzt, dass sie Epoxidendgruppen enthalten und dadurch mit den Epoxiden durch einen Härter vernetzt werden können.

Ansonsten werden Klebmassen mit Polyamidimiden sehr spezieller Zusammensetzung zum Beispiel in US 6,121,553 A offenbart.

In WO 00/01782 A1 werden Klebmassen auch auf Basis von Polyamiden und vernetzenden Harzen beschrieben. Allerdings reagieren in diesen Klebmassen die Epoxidharze mit einem Härter und bilden so ein dreidimensionales Netzwerk, das Polyamid dient nur als Flexibilisierungsmittel.

In DE 42 24 567 A1 werden Klebeschichten aus einem Polyamidharz mit einer Aminzahl von mindestens 3 und einem Epoxydharz beschrieben.

Aufgabe der Erfindung war es somit, ein Klebeband bereitzustellen, dass hitzeaktivierbar ist, in der Hitze vernetzt, eine geringe Viskosität in der Hitze besitzt, gute Haftung auf Polyimid zeigt und im unvernetzten Zustand löslich in organischen Lösungsmitteln ist.

Gelöst wird diese Aufgabe überraschend durch ein Klebeband, wie es in dem Hauptanspruch näher gekennzeichnet ist. Gegenstand der Unteransprüche sind vorteilhafte Weiterentwicklungen des Erfindungsgegenstandes sowie Verwendungsmöglichkeiten desselben.

Demgemäß ist Gegenstand der Erfindung ein hitzeaktivierbares Klebeband insbesondere für die Herstellung und Weiterverarbeitung von elektronischen Bauteilen und Leiterbahnen mit einer Klebemasse, die zumindest aus
a) einem Polyamid mit Amino- und/oder Säureendgruppen,
b) einem Epoxidharz,
c) einem Weichmacher
besteht, wobei das Polyamid bei Temperaturen von mindestens 150 °C mit dem Epoxidharz reagiert und das Verhältnis in Gewichtsanteilen von a) und b) zwischen 50:50 bis 99:1 liegt.

Der allgemeine Ausdruck Klebeband umfasst im Sinne dieser Erfindung alle flächigen Gebilde wie in zwei Dimensionen ausgedehnte Folien oder Folienabschnitte, Bänder mit ausgedehnter Länge und begrenzter Breite, Bandabschnitte, Stanzlinge und dergleichen.

Vorzugsweise liegt das Verhältnis in Gewichtsanteilen von a) und b) zwischen 70:30 bis 95:5.

Die in den erfindungsgemäßen Klebmassen eingesetzten Polyamide sollten ein nicht zu hohes Molekulargewicht (vorzugsweise ein gewichtsmittleres Molekulargewichte M_{w} kleiner 40000) aufweisen und flexibilisiert beziehungsweise nur zum Teil oder gar nicht kristallin sein. Dieses ist zum einen für die beschriebene Flexibilität der Klebmassen erforderlich, zum anderen werden die Rohstoffe vorzugsweise aus der Lösung verarbeitet und vollständig kristalline Polyamide lassen sich nur schwer und in nicht konvenienten Lösungsmitteln wie Trifluoressigsäure oder Schwefelsäure lösen.

Deshalb werden gemäß einer vorteilhaften Weiterführung der Erfindung statt der Homopolymere wie PA 6,6 Copolymere verwendet. Zur Flexibilisierung des PA 6,6 kann dieses mit PA 6 copolymerisiert werden. Andere Copolymere wie zum Beispiel PA 6,6/6,12 oder PA 6,6/6,11 sind ebenfalls einsetzbar. Durch eine Verringerung des Molekulargewichts wird die Löslichkeit der Polyamide erhöht. Das Molekulargewicht sollte dabei nicht soweit abgesenkt werden, dass die guten mechanischen Eigenschaften dabei verloren gehen.

Das gewichtsmittlere Molekulargewicht M_{w} sollte größer als 500 g/mol sein.
Um die Kristallinität weiter zu senken, ist auch der Einsatz von Terpolymeren möglich. Es können nicht nur rein aliphatische Polyamide zum Einsatz kommen, auch aliphatisch aromatische Polyamide sind verwendbar. Dabei sind solche bevorzugt, die eine lange aliphatische Kette oder am besten durch Copolymerisation unterschiedlich lange aliphatische Ketten enthalten. Eine Verbesserung der Löslichkeit kann hier auch durch den Einsatz von Aromaten mit meta- beziehungsweise ortho-Substitution erfolgen. Der Einsatz von Isophthalsäure statt Terephthalsäure senkt die Kristallinität erheblich. Um in aliphatisch-aromatischen Polyamiden die Kristallinität zu senken, sind auch Monomere der folgenden Formel einsetzbar:

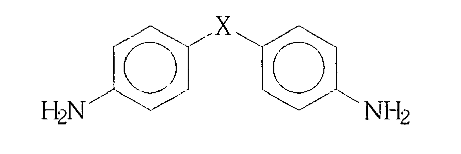

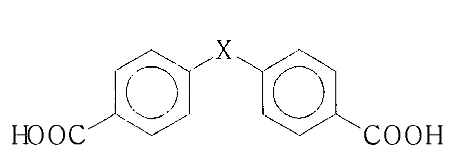

Dabei kann X für Sauerstoff, Stickstoff oder Schwefel stehen, aber auch eine Alkylengruppe mit mindestens einem Kohlenstoffatom bedeuten. Auch eine Isopropylen-Gruppe ist möglich.

Ebenfalls sind Erweiterungen dieser Strukturen möglich durch Substituenten an den Aromaten oder durch Verlängerung der Struktur durch weitere Aromatengruppen. Weitere Beispiele für erfindungsgemäß einsetzbare Amine sind in der US 6,121,553 A genannt.
Auch Polyesteramide sind einsetzbar, vorausgesetzt, sie lassen sich in einem Lösungsmittel lösen, das für das Aufbringen auf einen Träger geeignet ist.

Wichtig für die Synthese der Polyamide ist, dass entweder die Aminokomponente(n) oder die Säurekomponente(n) in einem Überschuss verwendet werden, damit zum einen das Molekulargewicht nicht zu hoch wird, zum anderen, damit endständige reaktive Gruppen vorhanden sind, die mit den Epoxidharzen reagieren können.
Da die Polyamide vernetzt werden, ist es auch möglich, recht niedermolekulare Oligomere (nämlich solche mit einem gewichtsmittleren Molekulargewichte M_{w} von 500 bis 2000 g/mol) einzusetzen, um eine ausreichende Festigkeit zu erhalten.

Als Epoxidharze werden üblicherweise sowohl monomere als auch oligomere Verbindungen mit mehr als einer Epoxidgruppe pro Molekül verstanden. Diese können Reaktionsprodukte von Glycidestern oder Epichlorhydrin mit Bisphenol A oder Bisphenol F oder Mischungen aus diesen beiden sein. Einsetzbar sind ebenfalls Epoxidnovolakharze, gewonnen durch Reaktion von Epichlorhydrin mit dem Reaktionsprodukt aus Phenolen und Formaldehyd. Auch monomere Verbindungen mit mehreren Epoxidendgruppen, die als Verdünner für Epoxidharze eingesetzt werden, sind verwendbar. Ebenfalls sind elastisch modifizierte Epoxidharze einsetzbar.

Beispiele von Epoxidharzen sind Araldite^{™} 6010, CY-281^{™}, ECN^{™} 1273, ECN^{™} 1280, MY 720, RD-2 von Ciba Geigy, DER^{™} 331, 732, 736, DEN^{™} 432 von Dow Chemicals, Epon^{™} 812, 825, 826, 828, 830 etc. von Shell Chemicals, HPT^{™} 1071, 1079 ebenfalls von Shell Chemicals, Bakelite^{™} EPR 161, 166, 172, 191, 194 etc. der Bakelite AG.

Kommerzielle aliphatische Epoxidharze sind zum Beispiel Vinylcyclohexandioxide wie ERL-4206, 4221, 4201, 4289 oder 0400 von Union Carbide Corp.

Elastifizierte Elastomere sind erhältlich von der Firma Noveon unter dem Namen Hycar. Epoxidverdünner, monomere Verbindungen mit mehreren Epoxidgruppen sind zum Beispiel Bakelite^{™} EPD KR, EPD Z8, EPD HD, EPD WF, etc. der Bakelite AG oder Polypox^{™} R 9, R12, R 15, R 19, R 20 etc. der Firma UCCP.

Gemäß einer bevorzugten Ausführungsform der Erfindung werden mehr als ein Epoxidharz gleichzeitig eingesetzt.

Durch die hohe Festigkeit der Polyamide und die zusätzliche Vernetzung mit den Epoxidharzen werden sehr große Festigkeiten innerhalb des Klebefilms erreicht. Aber auch die Verklebungsfestigkeiten zum Polyimid sind ausgesprochen hoch.

Idealerweise werden die Epoxidharze und die Polyamide in einem Mengenverhältnis eingesetzt, dass der molare Anteil an Epoxidgruppen und Aminogruppen beziehungsweise Säuregruppen gerade äquivalent ist.
Das Verhältnis zwischen Härtergruppen und Epoxidgruppen kann aber in weiten Bereichen variiert werden, dabei sollte für eine ausreichende Vernetzung keine der beiden Gruppen in mehr als einem zehnfachen moläquivalenten Überschuss vorliegen.

Zur zusätzlichen Vernetzung ist es auch möglich, chemische Vernetzer zuzusetzen, die mit den Epoxidharzen reagieren. Vernetzer sind für die Reaktion nicht nötig, können aber besonders, um einen Überschuss an Epoxidharz abzufangen, zugegeben werden.
Als Vernetzer beziehungsweise Härter kommen hauptsächlich folgende Verbindungen zu Einsatz, wie sie in der US 3,970,608 A näher beschrieben sind:
- Mehrwertige aliphatische Amine wie zum Beispiel Triethylentetramin
- Mehrwertige aromatische Amine wie zum Beispiel Isophorondiamin
- Guanidine wie zum Beispiel Dicyandiamid
- Mehrwertige Phenole
- Mehrwertige Alkohole
- Mehrwertige Mercaptane
- Mehrwertige Carbonsäuren
- Säureanhydride mit einer oder mehreren Anhydridgruppen

Klebebänder auf der Basis von Polyamid und Epoxidharz mit und ohne Härter können zwar sehr hohe Halteleistungen erreichen, der Erweichungspunkt dieser Klebmassen ist vergleichsweise hoch, was in gewissen Fällen die Verarbeitung einschränkt. Da die Klebebänder vor einer Verpressung auf den zu verklebenden Gegenstand laminiert werden, ist eine sehr hohe Temperatur von über 160 °C nötig. Um diese Temperatur herabzusetzen, werden gemäß der Erfindung den Klebmassen Weichmacher zugesetzt. Versuche zeigen auch, dass die Stabilität nach Lagerung bei weichmacherabgemischten Klebmassen auf Polyamidbasis deutlich höher ist als bei solchen ohne Zusatz von Weichmachern. Neben der Laminiertemperatur kann durch die Zugabe von Weichmachern auch die Vernetzungstemperatur gesenkt werden, gleichzeitig wird die Lagerungsstabilität erhöht.

Als Weichmacher kommen zum einen die typischerweise in PVC eingesetzten Weichmacher in Frage.
Diese können zum Beispiel gewählt werden aus den Gruppen der
- Phthalate wie DEHP (Diethylhexylphthalat), DBP (Dibutylphthalat), BBzP (Butylbenzylphthalat), DnOP (Di-n-octylphthalat), DiNP (Di-iso-nonylphthalat), DiDP (Di-iso-decylphthalat)
- Trimellitate wie TOTM (Trioctyltrimellitat), TINTM (Triisononyltrimeilitat)
- Aliphatische Dicabonsäureester wie DOM (Dioctylmaleat), DOA (Dioctyladipat), DINA (Diisononyladipat)
- Phosphorsäureester wie TCEP (Tris(2-chlorethyl)phosphat)
- natürlichen Ölen wie Rizinusöl oder Campher

Zudem sind auch folgende Weichmacher einsetzbar:
- niedermolekulare Polyalkylenoxide, wie Polyethylenoxide, Polypropylenoxide und PolyTHF
- Klebharze auf der Basis von Kolophonium mit niedrigem Erweichungspunkt wie Abalyn oder Foralyn 5040 der Firma Eastman

Bevorzugt sind dabei die letzten beiden Gruppen wegen ihrer besseren Umweltverträglichkeit und der geringeren Neigung, aus dem Klebmasseverbund hinauszudiffundieren.
Auch Mischungen der einzelnen Weichmacher sind einsetzbar.

Um die Reaktionsgeschwindigkeit der Vernetzungsreaktion zu erhöhen, ist der Einsatz von so genannten Beschleunigern möglich.
Beschleuniger können zum Beispiel sein:
- tertiäre Amine wie Benzyldimethylamin, Dimethylaminomethylphenol, Tris(dimethylaminomethyl)phenol
- Bortrihalogenid-Amin-Komplexe
- substituierte Imidazole
- Triphenylphosphin

Als weitere Additive können typischerweise genutzt werden:
- primäre Antioxidanzien wie zum Beispiel sterisch gehinderte Phenole
- sekundäre Antioxidanzien wie zum Beispiel Phosphite oder Thioether
- Prozessstabilisatoren wie zum Beispiel C-Radikalfänger
- Lichtschutzmittel wie zum Beispiel UV-Absorber oder sterisch gehinderte Amine
- Verarbeitungshilfsmittel
- Füllstoffe wie zum Beispiel Siliziumdioxid, Glas (gemahlen oder in Form von Kugeln), Aluminiumoxide, Zinkoxide, Calciumcarbonate, Titandioxide, Ruße, Metallpulver, etc.
- Farbpigmente und Farbstoffe sowie optische Aufheller

Zur Herstellung des Klebebandes werden die Bestandteile der Klebmasse in einem geeigneten Lösungsmittel, zum Beispiel heißem Ethanol, heißem Methanol, N-Methylpyrrolidon, Dimethylformamid, Dimethylacetamid, Dimethylsulfoxid, γ-Butyrolacton oder halogenierten Kohlenwasserstoffen oder Gemischen der vorgenannten, gelöst und auf ein flexibles Substrat, das mit einer Releaseschicht versehen ist, zum Beispiel einem Trennpapier oder einer Trennfolie beschichtet und getrocknet, so dass die Masse von dem Substrat leicht wieder entfernt werden kann. Nach entsprechender Konfektionierung können Stanzlinge, Rollen oder sonstige Formkörper bei Raumtemperatur hergestellt werden. Entsprechende Formkörper werden dann vorzugsweise bei erhöhter Temperatur auf das zu verklebende Substrat, zum Beispiel Polyimid, aufgeklebt.

Es ist auch möglich, die Klebmasse direkt auf einen Polyimidträger zu beschichten. Solche Klebfolien können dann zur Abdeckung von Kupferleiterbahnen für FPCBs eingesetzt werden.

Es ist nicht erforderlich, dass die Verklebung als einstufiges Verfahren erfolgt, sondern auf eines der beiden Substrate kann zunächst das Klebeband geheftet werden, indem man in der Wärme laminiert. Beim eigentlichen Heißklebeprozess mit dem zweiten Substrat (zweite Polyimidfolie oder Kupferfolie) härten die Epoxidgruppen dann ganz oder teilweise aus, und die Klebstofffuge erreicht die hohe Verklebungsfestigkeit.
Die zugemischten Epoxidharze und die Polyamide sollten vorzugsweise bei der Laminiertemperatur noch keine chemische Reaktion eingehen, sondern erst bei der Heißverklebung miteinander reagieren.

Die hergestellten Klebmassen haben gegenüber vielen gebräuchlichen Klebmassen zur Verklebung von FPCBs den Vorteil, nach der Verklebung eine sehr hohe Temperaturstabilität zu besitzen, so dass der geschaffene Verbund auch noch bei Temperaturen von über 150 °C sehr fest ist.

Vorteil der erfindungsgemäßen Klebmassen ist, dass das Elastomer tatsächlich chemisch mit dem Harz vernetzt, eine Zugabe eines Härters für das Epoxidharz ist nicht notwendig, da das Elastomer selbst als Härter wirkt.

Dabei kann die Vernetzung sowohl über endständige Säuregruppen als auch über endständige Aminogruppen stattfinden. Auch eine Vernetzung über beide Mechanismen gleichzeitig ist möglich. Damit genügend Endgruppen vorhanden sind, darf das Molekulargewicht der Polyamide nicht zu hoch sein, da ansonsten der Vernetzungsgrad zu gering wird. Molekulargewichte über 40.000 führen zu nur wenig vernetzten Produkten.

Die Molekulargewichtsbestimmungen der gewichtsmittleren Molekulargewichte M_{w} erfolgten mittels Gelpermeationschromatographie (GPC). Als Eluent wurde THF (Tetrahydrofuran) mit 0,1 Vol.% Trifluoressigsäure eingesetzt. Die Messung erfolgte bei 25 °C. Als Vorsäule wurde PSS-SDV, 5 µ, 10³ Å, ID 8,0 mm x 50 mm verwendet. Zur Auftrennung wurden die Säulen PSS-SDV, 5 µ, 10³ sowie 10⁵ und 10⁶ mit jeweils ID 8,0 mm x 300 mm eingesetzt. Die Probenkonzentration betrug 4 g/l, die Durchflussmenge 1,0 ml pro Minute. Es wurde gegen PMMA-Standards gemessen.

### Beispiele

Im Folgenden wird die Erfindung durch einige Beispiele näher beschrieben, ohne dabei die Erfindung in irgendeiner Weise zu beschränken.

### Vergleichsbeispiel 1

90 Teile eines Copolyamid 6/66/136 mit einer Viskositätszahl in 96 %iger Schwefelsäure nach ISO 307 von 122 ml/g (Ultramid 1C der Firma BASF) werden unter Rühren in siedendem Ethanol gelöst (20 %ige Lösung), und die abgekühlte Lösung mit 10 Teilen des Epoxidharzes EPR 161 (Firma Bakelite, Epoxidzahl von 172) versetzt.
Nach vollständiger Lösung der Komponenten wird die Lösung auf einem silikonisierten Träger ausgestrichen, so dass man nach Trocknen einen Klebefilm von 25 µm erhält.

### Vergleichsbeispiel 2

90 Teile des oben beschriebenen Copolyamids, bei dem die Aminoendgruppen mit Benzoesäurechlorid umgesetzt werden, werden wie oben beschrieben in Ethanol gelöst und mit EPR 161 (10 Teilen) versetzt.

### Vergleichsbeispiel 3

Herstellung einer Klebmasse analog Beispiel 1, mit den Verhältnissen von Polyamid zu Epoxidharz von 40:60.

### Beispiel 4

90 Teile eines Copolyamid 6/66/136 mit einer Viskositätszahl in 96 %iger Schwefelsäure nach ISO 307 von 122 ml/g (Ultramid 1C der Firma BASF) werden unter Rühren in siedendem Ethanol gelöst (20% ige Lösung), und die abgekühlte Lösung mit 10 Teilen des Epoxidharzes EPR 166 (Firma Bakelite, Epoxidzahl von 184), 20 Teilen eines Polyethylenglycols mit der mittleren Molmasse 2000 und dem Klebharz Foralyn 5040 der Firma Eastman versetzt.
Nach vollständiger Lösung der einzelnen Bestandteile wird die Lösung auf einem silikonisierten Träger ausgestrichen, so dass man nach Trocknen einen Klebefilm von 25 µm erhält.

### Vergleichsbeispiel 5

Das Polyamid wird wie in Beispiel 4 gelöst, diesmal wird auf die Zugabe der beiden Weichmacher verzichtet. Wiederum wird wie oben beschrieben ein Klebmassefilm der Dicke 25 µm ausgestrichen.

### Beispiel 6

Die Einsatzstoffe wie in Beispiel 4, zusätzlich werden noch 2 Teile Dicyandiamid als Härter für das Epoxidharz hinzugegeben.

### Vergleichsbeispiel 7

90 Teile des oben beschriebenen Copolyamids, bei dem die Aminoendgruppen mit Benzoesäurechlorid umgesetzt werden, werden wie oben beschrieben in Ethanol gelöst und mit EPR 161 (10 Teilen) und den beiden Weichmachern aus Beispiel 4 versetzt.

### Verklebung von FPCBs mit dem hergestellten Klebeband

Zwei FPCBs werden jeweils mit den nach den Beispielen 1 bis 3 hergestellten Klebebändern verklebt. Dazu wird das Klebeband auf die Polyimidfolie des FPCB-Laminats aus Polyimid/Kupferfolie bei 170 °C auflaminiert. Anschließend wird eine zweite Polyimidfolie eines weiteren FPCBs auf das Klebeband geklebt und der ganze Verbund in einer beheizbaren Bürklepresse bei 200 °C bei einem Druck von 1,3 MPa für eine Stunde verpresst.

Zwei FPCBs werden jeweils mit den nach den Beispielen 4 bis 7 hergestellten Klebebändern verklebt. Dazu wurde das Klebeband auf die Polyimidfolie des FPCB-Laminats aus Polyimid/Kupferfolie bei 140 °C beziehungsweise 170 °C auflaminiert. Anschließend wird eine zweite Polyimidfolie eines weiteren FPCBs auf das Klebeband geklebt, und der ganze Verbund in einer beheizbaren Bürklepresse bei 200 °C bei einem Druck von 1,3 MPa für eine Stunde verpresst.

### Prüfmethoden

Die Eigenschaften der nach den oben genannten Beispielen hergestellten Klebstofffolien werden mit folgenden Testmethoden untersucht.

### Laminiertemperatur

Es wird die Mindesttemperatur bestimmt, bei der das Klebeband auf einen Polyimidträger auflaminiert werden kann, ohne sich von selbst zu lösen.

### T-Peel-Test mit FPCB

Mit einer Zugprüfmaschine der Firma Zwick werden die nach dem oben beschriebenen Verfahren hergestellten Verbunde aus FPCB/Klebeband/FPCB im 180° Winkel mit einer Geschwindigkeit von 50 mm/min auseinander gezogen und die benötigte Kraft in N/cm gemessen. Die Messungen werden bei 20 °C und 50 % rel. Feuchte durchgeführt. Jeder Messwert wird dreifach bestimmt.

### Temperaturbeständigkeit

Analog zum beschriebenen T-Peel-Test werden die nach dem oben beschriebenen Verfahren hergestellten FPCB-Verbunde so aufgehängt, dass einer der beiden entstandenen Anfasser oben befestigt wird, am anderen Anfasser wird ein Gewicht von 500 g befestigt, so dass sich zwischen den beiden FPCBs ein Winkel von 180° ausbildet. Es wird nun die Temperatur bestimmt, bei der nach 30 min ein Schälweg von mehr als 10 mm gemessen werden kann.

### Lötbadbeständigkeit

Die nach dem oben beschriebenen Verfahren verklebten FPCB-Verbunde werden für 10 Sekunden auf ein 288°C heißes Lötbad gelegt. Die Verklebung wird als lötbadbeständig gewertet, wenn sich keine Luftblasen bildeten, welche die Polyimidfolie des FPCBs aufblähen lassen. Der Test wird als nicht bestanden gewertet, wenn bereits eine leichte Blasenbildung eintritt.

### Ergebnisse:

Zur klebtechnischen Beurteilung der oben genanten Beispiele wird zunächst der T-Peel-Test durchgeführt.

Die Ergebnisse sind Tabelle 1 zu entnehmen.

**Tabelle 1**

| | |
|---|---|
| Vergleichsbeispiel 1 | T-Peel Test [N/cm] Delamination des Kupfer-Poyimidverbundes bei ca. 15 N/cm. Kein Versagen der Verklebung mit erfindungsgemäßem Klebeband |
| Vergleichsbeispiel 2 | 1,8 |
| Vergleichsbeispiel 3 | Sehr spröde, keine flexible Verklebung möglich |
| Beispiel 4 | Delamination des Kupfer-Poyimidverbundes bei ca. 15 N/cm. Kein Versagen der Verklebung mit erfindungsgemäßem Klebeband |
| Vergleichsbeispiel 5 | Delamination des Kupfer-Poyimidverbundes bei ca. 15 N/cm. Kein Versagen der Verklebung mit erfindungsgemäßem Klebeband |
| Beispiel 6 | Delamination des Kupfer-Poyimidverbundes bei ca. 15 N/cm. Kein Versagen der Verklebung mit erfindungsgemäßem Klebeband |
| Vergleichsbeispiel 7 | 1,8 |

Wie zu erkennen ist, konnte im Vergleichsbeispiel, 1 eine flexible Klebmasse hergestellt werden, die für die Anwendung exzellent geeignet ist und sehr hohe Verklebungsfestigkeiten aufweist.
Wenn das Polyamid nicht mit den Epoxidharzen reagieren kann, ergeben sich deutlich niedrigere Werte in der Klebkraft als nach einer erfolgten Reaktion.
Durch einen zu hohen Gehalt an Epoxidharz werden die Klebmassen zu spröde für die Anwendung.

Auch in den Beispielen 4 und 6 konnten flexible Klebmassen hergestellt werden, die für die Anwendung exzellent geeignet sind und sehr hohe Verklebungsfestigkeiten aufweisen.
Auch Vergleichsbeispiel 5 zeigte gute Verklebungsfestigkeiten, ist nur in der Verarbeitung eingeschränkt durch die sehr hohe Laminiertemperatur.

Wenn das Polyamid nicht mit den Epoxidharzen reagieren kann wie in Vergleichsbeispiel 7, ergeben sich deutlich niedrigere Werte in der Klebkraft als nach einer erfolgten Reaktion.

Die Temperaturbeständigkeit der Klebebänder wird mit dem statischen Peel-Test gemessen, dessen Werte in Tabelle 2 zu finden sind.

**Tabelle 2**

| | |
|---|---|
| Vergleichsbeispiel 1 | Statischer T-Peel-Test [Versagenstemperatur in °C]] Bei 180 °C Delamination des Kupfer-Imid-Verbundes, noch kein Versagen des Erfindungsgemäßen Klebers |
| Vergleichsbeispiel 2 | Versagen bei 65 °C |
| Vergleichsbeispiel 3 | Sehr spröde, keine flexible Verklebung möglich |
| Beispiel 4 | 160 °C |
| Vergleichsbeispiel 5 | Bei 180 °C Delamination des Kupfer-Imid-Verbundes, noch kein Versagen des erfindungsgemäßen Klebers. |
| Beispiel 6 | 170 °C |
| Vergleichsbeispiel 7 | 65 °C |

Wie zu erkennen ist, ist bei dem Referenzmuster 2 die Temperaturbeständigkeit deutlich niedriger als bei Vergleichsbeispiel 1. Es zeigt sich, dass die Temperaturstabilität des vernetzten Musters besser ist als bei dem nicht vernetzenden.

Trotz der Zugabe der Weichmacher ist die Verklebungsfestigkeit auch bei hohen Temperaturen fast ebenso hoch wie bei dem Vergleichsbeispiel 5.

Durch die Zugabe von Weichmachern ist es auch möglich, die Reaktionstemperatur zu senken, beim Pressen bei 180 °C statt wie oben beschriebene 200 °C erhält man bei den Beispielen 4 und 6 ähnlich hohe Klebkräfte, während Vergleichsbeispiel 5 nur unvollständig vernetzt, so dass die Klebkräfte deutlich sinken.

Dieselben Tests wie oben beschrieben wurden nach einer Lagerung der unverklebten Muster bei Raumtemperatur nach 6 Monaten mit den Beispielen 4 bis 6 wiederholt. Während die Muster 4 und 6 sehr ähnliche Werte zeigten und immer noch sehr hohe Verklebungsfestigkeiten aufwiesen, ist das Vergleichsbeispiel 5 deutlich schwächer geworden, die Klebkraft im T-Peel-Test lag jetzt bei 2 N/cm.

Der Lötbadtest wurde von Beispiel 1 und 2 bestanden sowie von den Beispielen 4 bis 6.

Bei der Bestimmung der Laminiertemperatur zeigte sich, dass die Beispiele 4, 6 und 7 mit Weichmacher sich bei 120 °C laminieren ließen, während es bei dem Beispiel 5 erst bei 170 °C möglich war.

## Patentansprüche

1. Hitzeaktivierbares Klebeband insbesondere für die Herstellung und Weiterverarbeitung von elektronischen Bauteilen und Leiterbahnen mit einer Klebemasse, die zumindest aus
a) einem Polyamid mit Amino- und/oder Säureendgruppen,
b) einem Epoxidharz,
c) einem Weichmacher besteht, wobei
das Polyamid bei Temperaturen von mindestens 150 °C mit dem Epoxidharz reagiert und
das Verhältnis in Gewichtsanteilen von a) und b) zwischen 50:50 bis 99:1 liegt.

2. Hitzeaktivierbares Klebeband nach Anspruch 1, **dadurch gekennzeichnet, dass** es sich bei dem Polyamid um ein nicht kristallines Copolyamid wie PA 6.6/6,12 oder PA 6,6/6,11 handelt.

3. Hitzeaktivierbares Klebeband nach Anspruch 1 oder 2, **dadurch gekennzeichnet, dass** die Viskositätszahl des Polyamids in 96 %iger Schwefelsäure nach ISO 307 gemessen 100 bis 130 ml/g beträgt.

4. Hitzeaktivierbares Klebeband nach zumindest einem der Ansprüche 1 bis 3, **dadurch gekennzeichnet, dass** der Weichmacher gewählt ist aus der Gruppe Phthalate, Trimellitate, Phosphorsäureester, natürliche Öle, Polyalkylenoxide, Kolophoniumharze und/oder Polyethylenglycol.

5. Hitzeaktivierbares Klebeband nach zumindest einem der vorigen Ansprüche, **dadurch gekennzeichnet, dass** der Anteil des Weichmacher zwischen 5 Gew.-% und 45 Gew.-% an der Gesamtmasse der Klebemasse beträgt.

6. Hitzeaktivierbares Klebeband nach zumindest einem der vorigen Ansprüche, **dadurch gekennzeichnet, dass** das Klebeband Beschleuniger, Farbstoffe, Ruß und/oder Metallpulver enthält.

7. Verwendung eines hitzeaktivierbaren Klebebands nach zumindest einem der vorigen Ansprüche zur Verklebung von Kunststoffteilen.

8. Verwendung eines hitzeaktivierbaren Klebebands nach zumindest einem der vorigen Ansprüche zur Verklebung von elektronischen Bauteilen und/oder von flexiblen gedruckten Schaltungen (FPCBs).

9. Verwendung eines hitzeaktivierbaren Klebebands nach zumindest einem der vorigen Ansprüche zur Verklebung auf Polyimid.

## Claims

1. Heat-activable adhesive tape particularly for producing and further processing electronic components and conductor tracks, with an adhesive composed at least of
a) a polyamide having terminal amino and/or acid groups,
b) an epoxy resin,
c) a plasticizer,
the polyamide reacting with the epoxy resin at temperatures of at least 150°C, and the ratio in weight fractions of a) to b) lying between 50:50 to 99:1.

2. Heat-activable adhesive tape according to Claim 1, **characterized in that** the polyamide is a non-crystalline copolyamide such as PA 6,6/6,12 or PA 6,6/6,11.

3. Heat-activable adhesive tape according to Claim 1 or 2, **characterized in that** the viscosity number of the polyamide in 96% strength sulphuric acid, measured in accordance with ISO 307, is 100 to 130 ml/g.

4. Heat-activable adhesive tape according to at least one of Claims 1 to 3, **characterized in that** the plasticizer is selected from the group of phthalates, trimellitates, phosphoric esters, natural oils, polyalkylene oxides, rosins and/or polyethylene glycol.

5. Heat-activable adhesive tape according to at least one of the preceding claims, **characterized in that** the fraction of the plasticizer is between 5% by weight and 45% by weight of the total mass of the adhesive.

6. Heat-activable adhesive tape according to at least one of the preceding claims, **characterized in that** the adhesive tape comprises accelerators, dyes, carbon black and/or metal powders.

7. Use of a heat-activable adhesive tape according to at least one of the preceding claims for bonding plastic parts.

8. Use of a heat-activable adhesive tape according to at least one of the preceding claims for bonding electronic components and/or flexible printed circuits (FPCBs).

9. Use of a heat-activable adhesive tape according to at least one of the preceding claims for bonding to polyimide.

## Revendications

1. Bande adhésive thermoactivable, en particulier pour la production et la transformation ultérieure de pièces électroniques et de pistes conductrices avec une masse adhésive qui est constituée par au moins
a) un polyamide avec des groupes terminaux amino et/ou acides,
b) une résine époxyde,
c) un plastifiant,
où
le polyamide réagit avec la résine époxyde à des températures d'au moins 150°C et
le rapport, en parties en poids, de a) et b) est situé entre 50:50 et 99:1.

2. Bande adhésive thermoactivable selon la revendication 1, **caractérisée en ce qu'**il s'agit pour le polyamide d'un copolyamide non cristallin tel que le PA 6, 6/6, 12 ou le PA 6,6/6,11.

3. Bande adhésive thermoactivable selon la revendication 1 ou 2, **caractérisée en ce que** l'indice de viscosité du polyamide dans de l'acide sulfurique à 96%, mesuré selon la norme ISO 307, est de 100 à 130 ml/g.

4. Bande adhésive thermoactivable selon au moins l'une quelconque des revendications 1 à 3, **caractérisée en ce que** le plastifiant est choisi dans le groupe formé par les phtalates, les trimellitates, les esters de l'acide phosphorique, les huiles naturelles, les poly(oxydes d'alkylène), les résines de colophonium et/ou le polyéthylèneglycol.

5. Bande adhésive thermoactivable selon au moins l'une quelconque des revendications précédentes, **caractérisée en ce que** la proportion du plastifiant représente entre 5% en poids et 45% en poids de la masse totale de la masse adhésive.

6. Bande adhésive thermoactivable selon au moins l'une quelconque des revendications précédentes, **caractérisée en ce que** la bande adhésive contient des accélérateurs, des colorants, de la suie et/ou de la poudre métallique.

7. Utilisation d'une bande adhésive thermoactivable selon au moins l'une quelconque des revendications précédentes pour le collage de pièces en matériau synthétique.

8. Utilisation d'une bande adhésive thermoactivable selon au moins l'une quelconque des revendications précédentes pour le collage de pièces électroniques et/ou de circuits imprimés souples (flexible printed circuit board - FPCB).

9. Utilisation d'une bande adhésive thermoactivable selon au moins l'une quelconque des revendications précédentes pour le collage sur du polyimide.
